# EUROPÄISCHE PATENTSCHRIFT

(11) **EP 2 831 303 B1**
(45) Veröffentlichungstag und Bekanntmachung des Hinweises auf die Patenterteilung: **02.01.2019**
(21) Anmeldenummer: 13711595.2
(22) Anmeldetag: 12.03.2013
(51) Int. Cl.: C23C 4/06, C21D 10/00, C23C 14/02, C23C 14/14, H01L 41/053, H01L 41/23, B32B 15/01, C23C 24/04, C23C 4/01

(54) **BESCHICHTUNGSVERFAHREN, OBERFLÄCHENSCHICHTSTRUKTUR SOWIE VERWENDUNGEN**
COATING METHOD, SURFACE LAYER STRUCTURE, AND USES THEREFOR
PROCÉDÉ DE REVÊTEMENT, STRUCTURE DE COUCHE DE SURFACE ET UTILISATIONS

(30) Priorität: 28.03.2012 DE 102012102690
(43) Veröffentlichungstag der Anmeldung: 04.02.2015
(60) Teilanmeldung: 18201292.2
(73) Patentinhaber: Airbus Defence and Space GmbH, 85521 Ottobrunn (DE)
(72) Erfinder: STORM, Stefan, 85716 Unterschleißheim (DE); BRANDL, Erhard, 85117 Eitensheim (DE); RAPS, Dominik, 81547 München (DE)
(74) Vertreter: Kastel, Stefan
(86) Internationale Anmeldenummer: PCT/EP2013/054936
(87) Internationale Veröffentlichungsnummer: WO 2013/143834

(56) Entgegenhaltungen:
- EP-A1- 0 215 223
- EP-A1- 1 500 638
- DE-A1-102006 025 172
- DE-A1-102006 057 641
- US-A- 3 774 428

## Beschreibung

Die Erfindung betrifft ein Beschichtungsverfahren gemäß dem Oberbegriff von Anspruch 1. Weiter betrifft die Erfindung ein mit einer nach dem Beschichtungsverfahren herstellbaren Beschichtung versehenes Piezokeramikbauteil.
In der industriellen Technik, der Fahrzeugtechnik, der Flugzeugtechnik, der Luft- und Raumfahrttechnik oder auch in anderen technischen Gebieten, wie beispielsweise der Prozesstechnik, Aktuatorik oder dergleichen, kommt es häufiger vor, dass Funktionsbauteile unter rauen Umgebungsbedingungen eingesetzt werden. Beispielsweise sind Aktoren unter Verwendung von Piezokeramiken bekannt. Bislang ist es schwierig, solche Piezokeramiken unter rauen Bedingungen wie feuchter, salzhaltiger Luft einzusetzen. Auch eine Verwendung in aggressiven Umgebungsbedingungen, wie sie zuweilen in der Prozesstechnik, der Verfahrenstechnik oder dergleichen vorkommen, ist schwierig.
So offenbart DE 10 2006 025 172 A1 ein eingangs genanntes Beschichtungsverfahren für einen Piezoaktor, um Schutz für einen axialen Piezoaktor zu schaffen.

Nun kommt es im Luftfahrtbetrieb häufig vor, dass derartige Piezoaktoren sehr stark durch Umweltbedingungen belastet werden. Zum Beispiel können innerhalb kurzer Zeit sehr hohe Temperaturgradienten oder auch Temperaturschwankungen auftreten, die die Bauteile aushalten müssen.
Auch mechanische Belastungen, die zu Kratzern führen können, sind für Piezoaktoren schädlich.

Es ist daher wünschenswert, unterschiedliche Piezoaktoren mit unterschiedlichen Funktionsschichten zu versehen, wobei der Schichtaufbau möglichst leichtgewichtig ausgestattet werden soll, höchst universell einsetzbar sein soll und unterschiedliche Funktionsschichten integrierbar sein sollen und dennoch das entsprechend beschichtete Bauteil hohen mechanischen und thermischen - insbesondere dynamischen - Belastungen Stand halten soll.
Diese Aufgabe wird durch ein Beschichtungsverfahren nach Anspruch 1 sowie eine Piezokeramikbauteil gemäß dem Nebenanspruch gelöst.
Vorteilhafte Ausgestaltungen der Erfindung sind Gegenstand der Unteransprüche. Die Erfindung schafft ein Beschichtungsverfahren zum Erzeugen einer Funktionsschicht auf einem Piezokeramikbauteil, mit den Schritten:
Bereitstellen einer ersten Materialschicht aus einem ersten Material mit einer höheren mechanischen Flexibilität als ein zweites Material an oder auf einem Piezokeramikbauteil,
Strukturieren der ersten Materialschicht, so dass die Materialschicht-Oberfläche der ersten Materialschicht eine dreidimensional ausgeformte Grundstruktur mit Erhebungen und Vertiefungen erhält, und
Beschichten der Materialschicht-Oberfläche der ersten Materialschicht mit einer zweiten Materialschicht aus dem zweiten Material derart, das die zweite Materialschicht im Wesentlichen die Grundstruktur der Materialschicht-Oberfläche mit den Erhebungen und Vertiefungen annimmt, wobei wenigstens einen der folgenden Schritte durchgeführt wird:
   a) ringförmiges Ausbilden der Erhebungen und Vertiefungen mit schräg zu einer Längsmittelachse des Piezokeramikbauteils verlaufenden Ringebenen oder
   b) Ausbilden der Erhebungen und Vertiefungen mit einem doppelschrägen Verlauf oder
   c) ringartiges Ausbilden der Erhebungen und Vertiefungen als konzentrische Ringe oder
   d) Ausbilden der Erhebungen und Vertiefungen als konzentrisch umlaufende geometrische Formen, insbesondere Rechtecke, Fünfecke oder Achtecke, oder als ellipsoide konzentrische Formen oder
   e) Ausbilden der Erhebungen und Vertiefungen mit einem schneckenförmigen Verlauf.
Zum Bereitstellen der ersten Materialschicht kann z.B. die erste Materialschicht bereits als Teil des Substrats vorhanden sein, oder die erste Materialschicht wird auf das Substrat aufgebracht. In einem Beispiel wird die erste Materialschicht durch Beschichtung einer Oberfläche eines Substrats mit dem ersten Material vorgesehen.

Gemäß einer bevorzugten Ausgestaltung ist vorgesehen, dass das erste Material ausgewählt wird aus einer Gruppe von Materialien, die Metall, Kunststoff und Keramik enthält.
Es ist bevorzugt, dass das zweite Material ausgewählt wird aus einer Gruppe von Materialien, die Metall, Kunststoff und Keramik enthält.
Vorzugsweise wird das erste und das zweite Material derart ausgewählt, dass das zweite Material weniger mechanisch flexibel bzw. robuster als das erste Material ist.

Vorzugsweise hat das zweite Material einen höheren E-Modul als das erste Material.

Vorzugsweise hat das zweite Material eine höhere Härte als das erste Material.

Vorzugsweise hat das zweite Material eine geringere Bruchdehnung oder Brucheinschnürung oder Bruchzähigkeit als das erste Material.

Vorzugsweise wird die erste Materialschicht als eine erste funktionelle Schicht oder eine erste Funktionsschicht ausgebildet, um so wenigstens eine erste Funktion bereitzustellen. Dies können ganz unterschiedliche Funktionen sein. Elektrische Isolation oder Feuchtigkeitsschutz können als Beispiele genannt werden.

Vorzugsweise wird die erste Materialschicht auch als Form zum Ausbilden der zweiten Materialschicht ausgebildet.

Vorzugsweise wird die zweite Materialschicht als eine zweite Funktionsschicht zur Bereitstellung wenigstens einer zweiten Funktion ausgebildet.

Die zweite Funktion kann ebenfalls sehr unterschiedlich sein. Die zweite Funktionsschicht kann beispielsweise eine Isolationsschicht zur elektrischen Isolierung sein. Weiter kann die zweite Funktionsschicht eine Schutzschicht gegen unterschiedliche Umwelteinflüsse sein. Beispielsweise kann die zweite Materialschicht als Schutzschicht gegen chemische Belastung ausgebildet sein. Beispielsweise kann die zweite Materialschicht als Schutzschicht gegen korrosive Belastung ausgebildet sein. Beispielsweise kann die zweite Materialschicht als Schutzschicht gegen Feuchtigkeit ausgebildet sein.

Beispielsweise kann die zweite Materialschicht als Schutzschicht gegen mechanische oder physikalische Belastung ausgebildet sein.

Bevorzugt ist die zweite Materialschicht eine Schutzschicht gegen thermische Belastung.

Bevorzugt ist die zweite Materialschicht eine elektrisch leitende Funktionsschicht oder alternativ eine elektrisch isolierende Funktionsschicht.

Bevorzugt ist die zweite Materialschicht zur Beeinflussung wenigstens eines Feldes ausgebildet. Beispielsweise ist die zweite Materialschicht als Feldbeeinflussungsschicht zum Beeinflussen von elektromagnetischen, elektrischen oder magnetischen Feldern ausgebildet. Beispielsweise ist die Feldbeeinflussungsschicht eine Abschirmschicht zum Abschirmen eines derartigen Feldes. Beispielsweise ist die Feldbeeinflussungsschicht eine Formschicht zur gezielten Ausformung des Feldes.

Bevorzugt wird die erste Materialschicht mikroskopisch strukturiert.

Vorzugsweise enthält der Schritt "Strukturieren der ersten Materialschicht" ein Strukturieren der ersten Materialschicht mittels eines energetischen Strahls. Als energetischer Strahl kann ein Laserstrahl vorgesehen sein. Als energetischer Strahl kann beispielsweise ein lonenstrahl vorgesehen sein. Als energetischer Strahl kann beispielsweise ein Elektronenstrahl vorgesehen sein. Als energetischer Strahl können andere Partikelstrahlen vorgesehen sein.

Vorzugsweise enthält der Schritt "Strukturieren der ersten Materialschicht" thermisches, vorzugsweise mikroskopisches, Strukturieren mittels einer Gegenform. Beispielsweise ist die Gegenform erhitzt oder eine heiße Gegenform.

Vorzugsweise wird die Grundstruktur auf der Materialschichtoberfläche geprägt.

Die Grundstruktur wird vorzugsweise, insbesondere in Form oder Größenabmessungen, ausgewählt aufgrund wenigstens eines der folgenden Kriterien:
- Belastungshöhe,
- Belastungsart,
- Verformungsweg,
- Umgebungseinflüsse.

Vorzugsweise hat die erste Materialschicht eine Dicke d₂, eine gleichbleibende oder sich entlang einer Erstreckung ändernde Amplitude zwischen Erhebungen und Vertiefungen y₂ und einen gleichbleibenden Abstand x₂ zwischen einer maximalen Erhebung und einer maximalen Vertiefung sowie einen Radius r₂ zur Krümmung an jeder Erhebung und Vertiefung. Jeder der Werte r2, x2, y2, d2 kann über die gesamte Oberflächenschichtstruktur gleich ausgebildet sein oder sich entlang einer ersten Richtung wegabhängig ändern.
Die Erfindung schafft ferner ein Piezokeramikbauteil mit einem Schutzschichtsystem zum Feuchteschutz und/oder zum Schutz gegen mechanische Beanspruchung, wobei das Schutzschichtsystem durch ein zuvor beschriebenes bevorzugtes Beschichtungsverfahren herstellbar ist.

Es ist bevorzugt, dass das erste Material ausgewählt ist aus einer Gruppe von Materialien, die Metall, Kunststoff, und Keramik enthält.
Das Substratmaterial und das erste Material können identisch sein. Z.B. kann die erste Materialschicht ein Teilbereich des Substrats sein, der auch nicht von dem übrigen Material des Substrats abgegrenzt sein muss. Gemäß einem weiteren Beispiel ist das erste Material, z.B. als Beschichtung oder dergleichen, auf das Substrat aufgebracht.

Es ist bevorzugt, dass das zweite Material ausgewählt ist aus einer Gruppe von Materialien, die Metall, Kunststoff und Keramik enthält.

Es ist bevorzugt, dass das zweite Material einen höheren E-Modul als das erste Material aufweist.

Es ist bevorzugt, dassdas zweite Material eine höhere Härte als das erste Material aufweist.

Es ist bevorzugt, dassdas zweite Material eine geringere Bruchdehnung als das erste Material aufweist.

Es ist bevorzugt, dass die erste Materialschicht
- eine Isolationsschicht zur elektrischen Isolierung,
- eine Schutzschicht gegen Feuchtigkeit und/oder
- eine elastische Pufferschicht zum elastischen Ausgleichen von Relativverschiebungen oder Relativbewegungen zwischen zweiter Materialschicht und Substrat ist
und/oder
dass die zweite Materialschicht
- eine Schutzschicht gegen chemische Belastung,
- eine Schutzschicht gegen mechanische oder physikalische Belastung,
- eine Schutzschicht gegen thermische Belastung,
- eine elektrisch leitende oder elektrisch isolierende Funktionsschicht, und/oder
- eine Feldbeeinflussungsschicht zum Beeinflussen von elektromagnetischen, elektrischen oder magnetischen Feldern
   ist.
wobei die erste Materialschicht mit einer zweiten Materialschicht aus dem zweiten Material beschichtet ist, wobei die zweite Materialschicht insgesamt im Wesentlichen entsprechend der Grundstruktur der Materialschicht-Oberfläche mit den Erhebungen und Vertiefungen ausgeformt ist.

Gemäß der Erfindung ein Piezokeramikbauteil mit einer Oberflächenschichtstruktur zur Bereitstellung einer Funktionsschicht auf auf mechanisch belasteten Bauteilen oder Oberflächen, mit einer ersten Materialschicht aus einem ersten Material mit einer höheren mechanischen Flexibilität als ein zweites Material, wobei die erste Materialschicht an oder auf einem Substrat vorgesehen ist, wobei die erste Materialschicht an der Materialschicht-Oberfläche eine dreidimensional ausgeformte Grundstruktur mit Erhebungen und Vertiefungen aufweist, und wobei die erste Materialschicht mit einer zweiten Materialschicht aus dem zweiten Material beschichtet ist, wobei die zweite Materialschicht insgesamt im Wesentlichen entsprechend der Grundstruktur der Materialschicht-Oberfläche mit den Erhebungen und Vertiefungen ausgeformt ist,
dadurch gekennzeichnet, dass die Erhebungen und Vertiefungen
a) ringförmig ausgebildet sind, jedoch die Ringebenen schräg zu einer Längsmittelachse des Piezokeramikbauteils verlaufen oder
b) mit einem doppelschrägen Verlauf versehen sind oder
c) ringartig als konzentrische Ringe vorgesehen sind oder
d) als konzentrische Rechtecke ausgebildet sind.
e) einen schneckenförmigen Verlauf der rillenartigen Erhebung beziehungsweise der benachbarten Vertiefung aufweisen.

Es ist bevorzugt, dass das erste Material ausgewählt ist aus einer Gruppe von Materialien, die Metall, Kunststoff, und Keramik enthält.
Das Substratmaterial und das erste Material können identisch sein. Z.B. kann die erste Materialschicht ein Teilbereich des Substrats sein, der auch nicht von dem übrigen Material des Substrats abgegrenzt sein muss. Gemäß einem weiteren Beispiel ist das erste Material, z.B. als Beschichtung oder dergleichen, auf das Substrat aufgebracht. Das erste Material kann auch z.B. eine Substratmatrix, wie z.B. Harz bei einem Faserverbundwerkstoff sein.

Es ist bevorzugt, dass das zweite Material ausgewählt ist aus einer Gruppe von Materialien, die Metall, Kunststoff und Keramik enthält.

Vorzugsweise bildet bei dem Beschichtungsverfahren oder der Oberflächenschichtstruktur die erste Materialschicht eine elastische Pufferschicht zum elastischen Ausgleichen von Relativverschiebungen oder Relativbewegungen zwischen der zweiten Materialschicht und dem Substrat. Hierdurch lassen sich bei statischen oder dynamischen, mechanischen oder thermischen Belastungen entsprechende Relativbewegungen ausgleichen.
Vorzugsweise entsteht eine Art Sandwichstruktur mit der zu beschichtenden Substratoberfläche auf der einen Seite und der härteren zweiten Materialschicht als Funktionsschicht auf der anderen Seite und einer elastischeren Zwischenschicht in Form der ersten Materialschicht. Die zweite Materialschicht erhält aufgrund der Grundstruktur entsprechende mechanische und thermische Ausgleichsmöglichkeiten. Beispielsweise gleicht die Grundstruktur, die die zweite Materialschicht annimmt, der Form eines Metallbalgs, der ziehharmonikaähnlich zusammengezogen und gestaucht werden kann.

Gemäß der Erfindung können die Erhebungen oder Vertiefungen schräg zur Längsachse verlaufen. Es ist eine Art Wendelstruktur möglich. Oder es ist eine schräge Struktur möglich, bei der Erhebungen oder Vertiefungen ringartig vorgesehen sind, wobei die Erstreckungsebene des Ringes schräg zur Mittelachse der zu beschichtenden Umfangsfläche erstreckend ausgebildet ist.

Nach Anspruch 1 können die Erhebungen oder Vertiefungen als konzentrische Ringe oder konzentrische Rechtecke oder Quadrate oder sonstige konzentrische umlaufende geometrische Formen (Sechsecke, Fünfecke, Achtecke usw.) ausgebildet sein. Auch ellipsoide konzentrische Formen sind möglich. Weiter können die Erhebungen und Vertiefungen auch schneckenförmig strukturiert sein.

Mit Hilfe der in dieser Erfindung beschriebenen Verfahren und Oberflächenschichtstrukturen oder deren vorteilhaften Ausgestaltungen werden Piezokeramikbauteile derart strukturiert, dass mindestens eine zusätzliche funktionale, mechanisch belastbare Schicht aufbringbar ist. Vorzugsweise dient diese zusätzliche funktionale, mechanisch belastbare Schicht als Schutz, z.B. vor korrosiver Belastung - z.B. Feuchtigkeit -, vor mechanischer Belastung - z.B. Kratzer - oder ist z.B. aus thermischen - z.B. erhöhter Wärmeabfuhr -, elektrischen oder induktiven Funktionsgründen vorgesehen.
Bisher sind keine derartig vergleichbaren Verfahren oder Oberflächenschichtstrukturen bekannt, die vergleichbare Eigenschaften und Möglichkeiten bieten könnten. Mit den vorgestellten Verfahren oder Schichtstrukturen ist es insbesondere möglich, Materialien mit höherem E-Modul, höherer Härte oder geringerer Bruchdehnung (im Vergleich zum beschichteten Substrat) auf eine stark mechanisch belastete Oberfläche aufzubringen, die einer hohen statische und/oder dynamischen Belastung Stand halten kann.
Im Folgenden werden Ausführungsbeispiele von Beschichtungsverfahren und damit beschichteten Bauteilen anhand der beigefügten Zeichnungen näher erläutert. Dabei zeigen:
- Fig. 1 bis Fig. 5: schematische Querschnittsdarstellungen unterschiedlicher Verfahrensschritte bei einem Beschichtungsverfahren zur Erzeugung einer funktionalen Schicht mit hoher Lebensdauer für mechanisch belastete Bauteile bzw. Oberflächen;
- Fig. 6: eine schematische Teilquerschnittdarstellung eines ersten Anwendungsbeispiels und ersten Ausführungsbeispiels für das Beschichtungsverfahren sowie einer damit herstellbaren Oberflächenschichtstruktur am Beispiel eines Feuchteschutzes für Piezokeramik, wobei eine Seitenansicht mit Schnitt durch die Oberflächenschichtstruktur angedeutet ist;
- Fig. 7: eine Draufsicht auf eine erste beispielhafte Ausgestaltung der mit Feuchteschutz versehenen Piezokeramik in länglicher Ausgestaltung mit rundem Querschnitt - Zylinderform -;
- Fig. 8: ein weiteres Ausführungsbeispiel für die mit Feuchteschutz versehene Piezokeramik in Draufsicht, wobei die Piezokeramik länglich mit eckiger Grundform (z.B. Balkenform) ausgestaltet ist;
- Fig. 9: eine Seitenansicht einer weiteren Ausführungsform mit einer zusätzlichen Schutzschicht;
- Fig. 10 bis 12: schematische Darstellungen einer zweiten äußeren Materialschicht des Feuchteschutzes mit Varianten für unterschiedliche Strukturierungen;
- Fig. 13: eine Seitenansicht auf ein weiteres Ausführungsbeispiel eines Piezokeramik-Bauteils mit Feuchteschutz, wobei die Piezokeramik als Scheibe oder Blatt ausgebildet ist;
- Fig. 14 bis 17: Draufsichten auf unterschiedliche Ausführungsbeispiele für die scheiben- oder plattenförmige Piezokeramik mit unterschiedlichen Varianten der Strukturierung des Feuchteschutzes;
- Fig. 18: eine Seitenansicht auf ein weiteres Ausführungsbeispiel eines Feuchteschutzes für eine Piezokeramik mit einem Beispiel einer möglichen Kabelanbindung;
- Fig. 19: eine schematische Querschnittsansicht durch ein weiteres Ausführungsbeispiel für eine mit dem Beschichtungsverfahren gemäß den Fig. 1 bis 5 herstellbare Oberflächenschichtstruktur am Beispiel einer Metallblechplatte mit Primerschicht und Lackschicht;
- Fig. 20: eine schematische Querschnittsdarstellung eines weiteren Bauteils mit einer Oberflächenschichtstruktur, die nach dem Beschichtungsverfahren gemäß den Fig. 1 bis 5 beschichtet worden ist, anhand eines Beispiels eines metallisierten Faserverbundmaterials;
- Fig. 21: eine schematische Darstellung eines weiteren Ausführungsbeispiels für eine mit dem Beschichtungsverfahren gemäß den Fig. 1 bis 5 herstellbare Oberflächenbeschichtung anhand einer funktionellen Schutzschicht für Festkörpergelenke aus Faserwerkstoff für UV-Schutz;
- Fig. 22: eine schematische Darstellung eines weiteren Ausführungsbeispiels für eine mit dem Beschichtungsverfahren gemäß den Fig. 1 bis 5 herstellbare Oberflächenbeschichtung anhand einer formvariablen Flügelvorderkante; und
- Fig. 23: eine schematische Darstellung eines weiteren Ausführungsbeispiels für eine mit dem Beschichtungsverfahren gemäß den Fig. 1 bis 5 herstellbare Oberflächenbeschichtung anhand einer Farbbeschichtung einer strukturierten Oberfläche zur Erzielung wechselnder Bildeffekte.

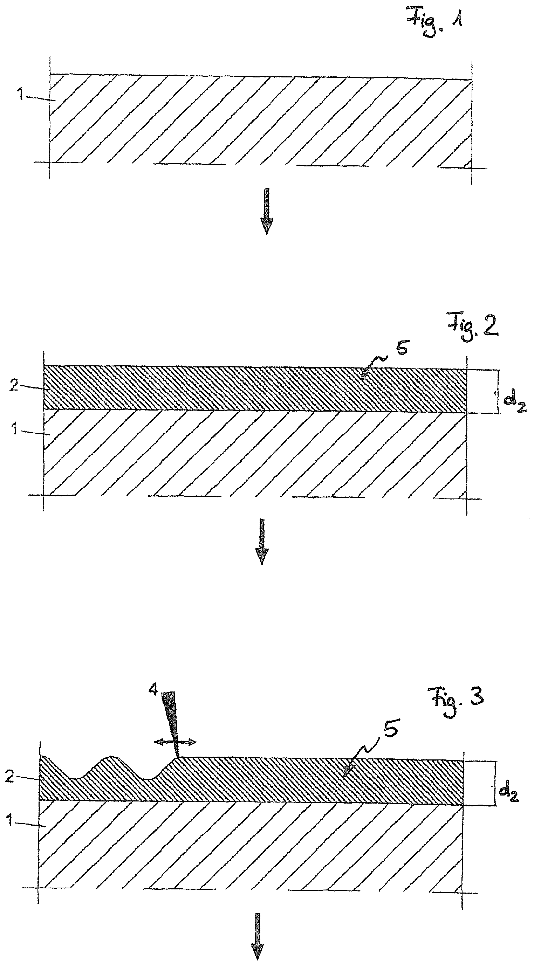

Im Folgenden wird zunächst anhand der Fig. 1 bis 5 ein Grundprinzip einer möglichen Ausführungsform für ein Beschichtungsverfahren erläutert.

In Fig. 1 ist hierbei ein erster Schritt des Bereitstellens eines Substrats 1 schematisch dargestellt.

In Fig. 2 ist ein zweiter Schritt des Beschichten des Substrats 1 mit einer ersten Materialschicht 2 aus einem ersten Material 5 mit einer Dicke d₂ auf einer Oberfläche des Substrats 1 dargestellt.

In Fig. 3 ist ein dritter Schritt des Beschichtungsverfahrens dargestellt. Dieser dritte Schritt betrifft eine Strukturierung einer Materialschicht-Oberfläche der ersten Materialschicht 2 auf der dem Substrat 1 abgewandten Seite mittels eines geeigneten Strukturierungswerkzeugs 4.

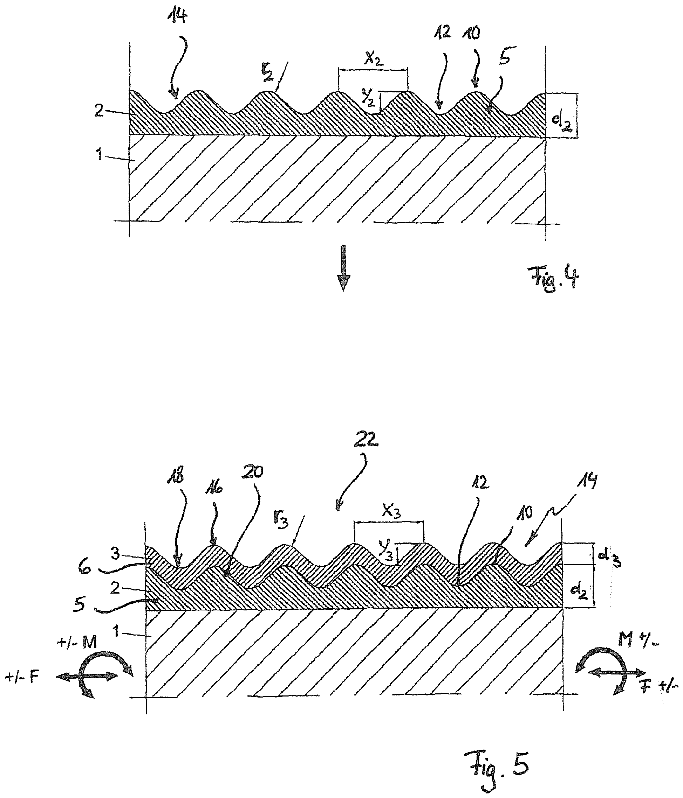

Wie Fig. 4 zeigt, entsteht auf dieser Materialschicht-Oberfläche eine Grundstruktur mit Erhebungen 10 und Vertiefungen 12.

Bei dem dargestellten Ausführungsbeispiel ist die Grundstruktur wellenartig ausgebildet.

Bei dem dargestellten Ausführungsbeispiel ist z.B. die Grundstruktur periodisch mit gleichbleibenden Abständen x₂ zwischen zwei Maximalerhebungen 10 und mit gleichbleibenden Abständen y₂ zwischen den jeweiligen maximalen Erhebungen 10 und dem tiefsten Punkt der Vertiefung 12 (in Richtung der Dicke d₂ gesehen) ausgebildet. An den Extrempunkten an den Erhebungen 10 und den Vertiefungen 12 ist die Grundstruktur 14 mit einem ebenfalls gleichbleibenden Radius r₂ versehen.

Fig. 5 zeigt den fünften Schritt des Beschichtungsverfahrens, wo auf die Grundstruktur 14 auf der Materialschicht-Oberfläche der ersten Materialschicht 2 eine zweite Materialschicht 3 aus einem zweiten Material 6 aufgebracht wird. Das Aufbringen erfolgt so, dass die zweite Materialschicht 3 entsprechend der Grundstruktur 14 geformt und mit etwa gleichbleibender Dicke d₃ dieser Grundstruktur mit allen Erhebungen 10 und Vertiefungen 12 folgt. Auf der dem Substrat 1 abgewandten freien Oberfläche der zweiten Materialschicht 3 sind demnach ebenfalls Erhebungen 16 und Vertiefungen 18 vorgesehen, die an den gleichen Stellen wie die Erhebungen 10 und Vertiefungen 12 auf der Grundstruktur 14 der Materialschicht-Oberfläche - Grenzfläche 20 zwischen den Materialschichten 2, 3 - vorgesehen sind. Die Maxima der Erhebungen 16 haben einen Abstand x₃. Die tiefsten Punkte der Vertiefungen 18 und die höchsten Punkte der Erhebungen 16 haben in Richtung der Dicke gesehen den Abstand y₃; und die Krümmungen an den Erhebungen 16 oder Vertiefungen 18 haben den Radius r₃.

Wie in Fig. 5 dargestellt, kann das Substrat sich aufgrund einer Kraft F in x-Richtung (z.B. Längsrichtung eines aus dem Substrat gebildeten Bauteils) verformen oder sich aufgrund eines Moments M um die Längsrichtung verdrehen oder verdrillen.

Als Substratmaterial des Substrats 1 können z.B. Metall, Keramik, Kunststoff oder Fasergewebe vorgesehen sein.

Als erstes Material 5 der ersten Materialschicht 2 können beispielsweise Metall, Kunststoff oder Keramik mit einer höheren mechanischen Verformbarkeit als das zweite Material 6 der zweiten Materialschicht 3 vorgesehen sein.

Als zweites Material 6 der zweiten Materialschicht 3 können beispielsweise Metall, Kunststoff oder Keramik mit geringerer mechanischer Verformbarkeit als das erste Material 5 vorgesehen sein.

Wie aus den Schritten der Fig. 1 bis 5 ersichtlich, wird das erste Material 5 als erste Materialschicht 2 auf das Substrat 1 aufgetragen und anschließend mikroskopisch strukturiert, bevorzugt mit einem energetischen Strahl 4, wie z.B. einem Laserstrahl, einem lonenstrahl oder Elektronenstrahl. Es ist auch vorstellbar, dass das Substrat 1 thermisch mit einer geeigneten strukturierten Gegenform - vergleichbar mit einem heißen Stempel oder Walze - strukturiert wird. Bei Letzterem wird vorausgesetzt, dass das Substrat 1 den mechanischen Druckbelastungen beim Prägevorgang Stand hält.

Die erste Materialschicht 2 mit dem ersten Material 5 dient als funktionale Schicht oder Funktionsschicht - z.B. als erste Funktion: elektrische Isolation oder Feuchtigkeitsschutz - und gleichzeitig als Form für die zweite Materialschicht 3.

Das erste Material 5 sollte so gewählt werden, dass die statischen oder dynamischen Lasten - Zug-/Druckkräfte F und/oder Drehmomente M - es rein elastisch bzw. nur geringfügig plastisch belasten.

Die zweite Materialschicht 3 wird auf das erste Material 5 der ersten Materialschicht 2 derart aufgetragen - z.B. Abscheidung aus gasförmiger Phase, thermisch Spritzen, Kaltgasspritzen oder galvanische Abscheidung -, dass es im Wesentlichen dessen Grundstruktur 14 übernimmt.

Je nach Belastungshöhe, Belastungsart, Verformungsweg und Umgebungseinflüssen wird eine geeignete Struktur auf der ersten Materialschicht 2 ausgewählt mit definierten Formabmessungen und Größenabmessungen - z.B. Radius r₂, Abstand x₂, Amplitude y₂ und Dicke d₂.

Die zweite Materialschicht 3 dient ebenfalls als funktionale Schicht oder Funktionsschicht. Zum Beispiel ist diese zweite Materialschicht 3 eine Schutzschicht zum Schutz vor korrosiver Belastung (z.B. Feuchtigkeit), vor mechanischer Belastung (z.B. Kratzer) oder ist z.B. aus thermischen Funktionsgründen (z.B. erhöhte Wärmeabfuhr), aus elektrischen Funktionsgründen und/oder aus induktiven Funktionsgründen vorgesehen. Zum Beispiel können unterschiedliche Abschirmmaßnahmen zum Abschirmen von unterschiedlichen Feldern (elektrische Felder, magnetische Felder, elektromagnetische Felder) vorgesehen sein. Es können aber auch gezielt Felder geformt oder beeinflusst werden.

Das zweite Material 6 der zweiten Materialschicht 3 ist mechanisch weniger flexibel bzw. robuster als das erste Material 5.

Zum Beispiel hat das zweite Material 6 einen höheren E-Modul, eine höhere Härte oder eine geringere Bruchdehnung als das erste Material 5.

Die gezielte geometrische Form - Grundstruktur 14 - ist vorteilhaft, damit diese entsprechend robuster/widerstandsfähiger ausgebildete zweite Materialschicht 3 auch der statischen und/oder dynamischen Belastung Stand halten kann. Diese gezielte geometrische Form wird durch die Strukturierung von der ersten Materialschicht 2 indirekt erzeugt.

Beispielsweise ist die zweite Materialschicht 2 aufgrund der wellenartigen Grundstruktur 14 wie ein Balg geformt und kann sich entsprechend stauchen oder strecken.

Das zweite Material 6 kann z.B. durch entsprechend gezielte geometrische Formung wie eine Feder wirken und hat bei einem bestimmten Verformungsweg eine geringere Beanspruchung wie eine ebene Schicht. Die entsprechend verformte zweite Materialschicht 3 verhält sich zu der ebenen Schicht insbesondere wie eine Feder zu einem Zugstab.

Mit diesem allgemeinen Beschichtungsverfahren, wie es anhand der Fig. 1 bis 5 erläutert worden ist, lassen sich ganz unterschiedliche Oberflächenschichtstrukturen 22 erzeugen.

Bei einer Abwandlung des anhand der Fig. 1 bis 5 erläuterten Verfahrens wird die erste Materialschicht als Teil des Substrats, z.B. als ein oberer Grenzschichtbereich des Substrats bereitgestellt. Mit anderen Worten bildet ein Teil des Substrats das erste Material; und im dritten Schritt wird die Oberfläche des Substrats entsprechend wie oben anhand des Beispiels einer gesondert aufgebrachten ersten Materialschicht erläutert strukturiert.

Besondere Ausführungsbeispiele werden im Folgenden näher erläutert.

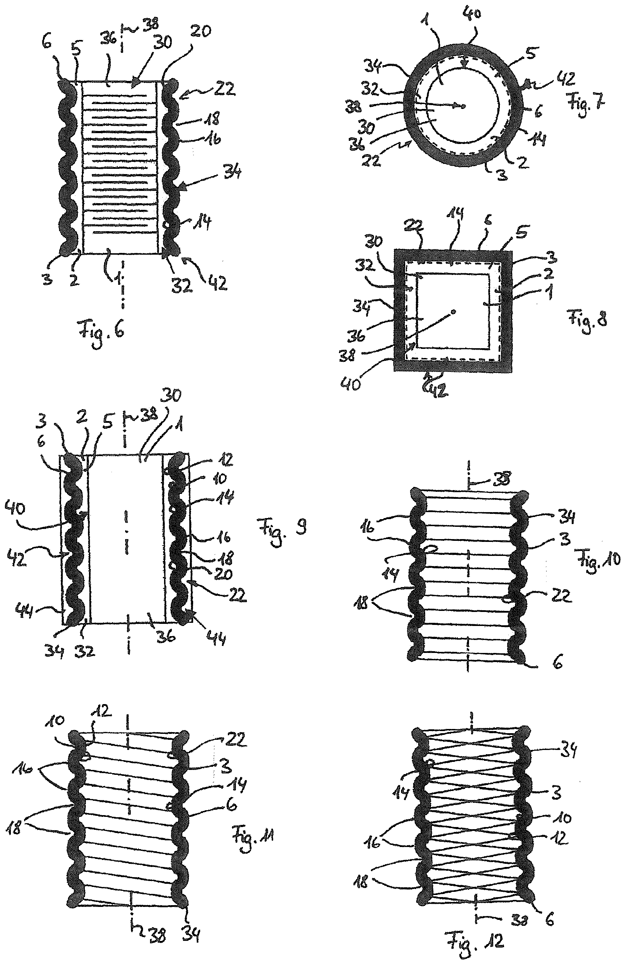

Dabei betreffen die Fig. 6 bis 18 ein erstes Ausführungsbeispiel, bei dem eine Piezokeramik aufgrund des Beschichtungsverfahrens mit einem Feuchteschutz versehen wird.

Wie in Fig. 6 gezeigt, ist als Substratmaterial 1 hierbei eine Piezokeramik 30 vorgesehen. Das aus der Piezokeramik 30 gebildete Bauteil kann sich entsprechend einer angelegten Spannung in einer bevorzugten Ausdehnungsrichtung - entsprechend der x-Richtung in Fig. 5 - ausdehnen oder zusammenziehen. Entsprechend lässt sich aus der Piezokeramik 30 ein Aktor zum Betätigen von mechanischen Bewegungen als Reaktion auf eine Spannungsänderung herstellen.

Gemäß den Fig. 6 bis 18 ist als erste Materialschicht 2 eine dünne Isolationsschicht 32 z.B. aus dem Material Parylene vorgesehen. Die Isolationsschicht hat eine Dicke d₂ im Bereich von 1 bis 50 µm, vorzugsweise zwischen 10 und 20 µm und am meisten bevorzugt ca. 15 µm. Entsprechend liegen die Dimensionen der einzelnen Schichten und der Werte r₂, x₂, y₂, d₂ unterhalb von 100 µm, insbesondere im Bereich zwischen 0,1 µm und 30 µm. Als zweite Materialschicht 3 ist eine Metallschicht vorgesehen. Beispielsweise ist Aluminium mit einer Dicke d₃ mit 1 bis 10 µm, vorzugsweise 5 µm, vorgesehen.

Bei dem Verfahren zur Herstellung der Oberflächenschichtstruktur 22 auf der Piezokeramik 30 strukturiert ein Laser die Parylene-Schicht 32 auf einer Piezokeramik 30. Anschließend wird eine Aluminiumschicht 34 aufgedampft. Über die Aktuatorik der Piezos wird eine dynamische Belastung induziert.

Durch diese Oberflächenschichtstruktur 22 ist ein sicherer Einsatz von Piezokeramik 30 unter rauen Umgebungsbedingungen wie feuchter, salzhaltiger Luft gewährleistet. Speziell bei hohen dynamischen Anforderungen an die Aktuatorik zeigt die Schutzschicht - Metallschicht 34 - sowohl eine sehr gute Dauerfestigkeit als auch einen geringen Wärmewiderstand bei hohen Umgebungstemperaturen auf.

Bislang war es üblich, dass Piezokeramiken mit einer Lackschicht ummantelt werden, um sie vor Feuchtigkeit zu schützen. Eine solche Lackschicht verzögert jedoch nur den Diffusionsprozess. Es kann lediglich die Zeit bis zum Erreichen des kritischen Feuchte-/Salzgehalts an der Keramikoberfläche über die Dicke der Lackschicht eingestellt werden. Es gilt hierbei: Je dicker die Lackschicht, desto weniger Wärme wird abgeführt. Austretende elektrische Felder erzwingen eine chemische Reaktion an der Lackoberfläche, die zu einer Zerstörung des Lackes führen kann.

Bei einem weiteren üblichen Lösungsansatz wird die Piezokeramik (sog. Stack) in einem Metallbalg mit Anschlussplatten gekapselt. Eine derartige Lösung bietet zwar einen sehr guten Schutz gegen jegliche Einflüsse von außen, jedoch geht sie mit einer deutlichen Gewichtszunahme und hohen Herstellkosten einher.

Bei dem hier verfolgten Lösungsansatz wird die Piezokeramik 30 zunächst mit einer dünnen Isolationsschicht 32 (z.B. Parylene, 15 µm) versehen. In einem weiteren Schritt wird diese Isolationsschicht 32 mittels Laser 4 oder dergleichen strukturiert und anschließend wird eine metallische Beschichtung - Metallschicht 34 - (z.B. Aluminium, 5 µm) aufgebracht. Damit eine metallische Beschichtung unter hoher dynamischer Belastung nicht ermüdet, ist es vorteilhaft, diese nicht ausschließlich einer Zugbelastung, sondern auch einer Biegebelastung auszusetzen. Die verwendete Struktur der aufgebrachten metallischen Beschichtung gleicht der Struktur eines Metallbalgs, der selbst bei hohen mechanischen Verformungen nur gering belastet wird. Die Metallschicht 34 bleibt somit dauerhaft intakt und bietet einen optimalen Feuchteschutz.

Herausragende Vorteile der hier dargestellten Oberflächenschichtstruktur 22 sind z.B.:
- eine sehr geringe Dicke der Schutzschicht 42 (gebildet aus den Schichten 32, 34; ca. 20 µm);
- ein elektrisches Feld ist nach außen gekapselt, so dass keine Elektrolyse auftritt;
- aufgrund dünnerer Schichten 32, 34 ist eine gute Wärmeabfuhr gegeben;
- wegen der Metallschicht 34 wird eine gute Wärmeverteilung erreicht;
- es gibt nahezu keine Gewichtszunahme;
- der Herstellungsprozess ist sehr einfach;
- die Piezokeramik 30 ist vor Berührungen geschützt;
- es gibt keinerlei Einschränkungen bei der Integration der Piezokeramik.

In den Fig. 6 bis 18 sind unterschiedliche mögliche Formen der Piezokeramik 30 mit Oberflächenschichtstruktur 22 dargestellt.

Fig. 6 zeigt hierbei eine Seitenansicht eines länglichen Piezokeramik-Bauteils 36, das sich bei Anlegung einer Spannung in Richtung seiner Längsmittelachse 38 ausdehnen oder zusammenziehen kann. Die parallel zur Längsmittelachse 38 verlaufende Umfangsoberfläche 40 ist mit der Schutzschicht 42 versehen, die aus der Isolationsschicht 32 - erste Materialschicht 2 - und der Metallschicht 34 - zweite Materialschicht 3 - gebildet ist.

Die Fig. 7 und 8 zeigen in Draufsicht unterschiedliche Grundflächenformen des Piezokeramik-Bauteils 36, es können - wie in Fig. 7 dargestellt - runde Formen oder - wie in Fig. 8 dargestellt - auch eckige Formen ausgebildet werden.

Fig. 9 zeigt ein weiteres Ausführungsbeispiel des mit der Schutzschicht 42 versehenen Piezokeramik-Bauteils 36, wobei außenseitig auf der Metallschicht 34 noch eine weitere Schutzschicht 44 als Kratzschutz vorgesehen ist. Die weitere Schutzschicht 44 hat vorzugsweise ebenfalls hohe elastische Eigenschaften, ähnlich dem ersten Material 5, um die Bewegungen beim Zusammenziehen oder Ausdehnen des Piezokeramik-Bauteils 36 entlang der Längsmittelachse 38 mitmachen zu können.

In den Fig. 10 bis 12 sind Beispiele für unterschiedliche Strukturierungen der Umfangsoberfläche 40 dargestellt.

Beispielsweise können die Erhebungen und Vertiefungen 16, 18 der zweiten Materialschicht 3 parallel ausgebildet sein, d.h. im Wesentlichen senkrecht zur Längsmittelachse 38 ausgebildet sein, wie dies in Fig. 10 dargestellt ist.

Fig. 11 zeigt eine weitere mögliche Ausgestaltung, bei der die Erhebungen und Vertiefungen 16, 18 ebenfalls ringförmig ausgebildet sind, wobei jedoch die Ringebenen nicht senkrecht zur Längsmittelachse 38, sondern schräg dazu verlaufen.

Fig. 12 zeigt ein weiteres Ausführungsbeispiel mit einem doppelschrägen Verlauf der Erhebungen 16 und Vertiefungen 18. Beispielsweise sind hier die Erhebungen und Vertiefungen wendelförmig ähnlich wie eine Gewindeoberfläche auf einem Schraubenschaft ausgebildet.

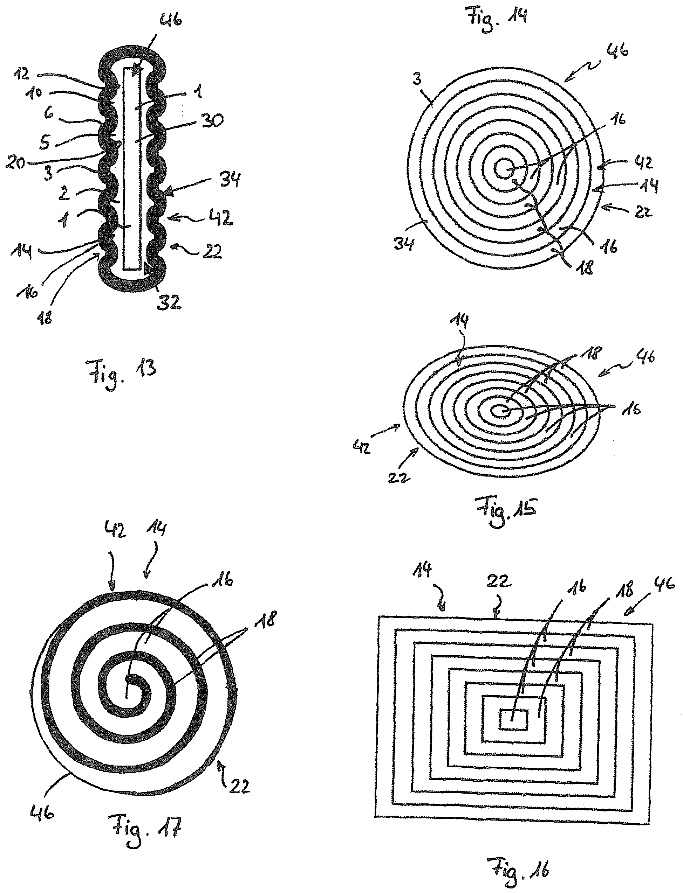

Während in den Fig. 6 bis 12 eine längliche Ausgestaltung eines Piezokeramik-Bauteils 36 in Längsausrichtung entlang einer Längsmittelachse 38 vorgesehen ist, so dass das Bauteil 36 z.B. stiftförmig oder stangenförmig ausgebildet ist, zeigen die weiteren schematischen in den Fig. 13 bis 17 dargestellten Ausführungsbeispiele ein Piezokeramik-Bauteil 46, das als Scheibe oder Platte ausgebildet ist. Zum Beispiel kann sich die Scheibe oder Platte je nach angelegter Spannung in der Plattenebene ausdehnen (z.B. Vergrößerung des Durchmessers oder Radius) oder verkleinern.

Wie in Fig. 13 dargestellt, ist auch dieses Piezokeramik-Bauteil 46 mit der Isolationsschicht 32 und der Metallschicht 34 versehen, die gemeinsam die Schutzschicht 42 als Feuchteschutz ausbilden.

Wie die Fig. 14 bis 17 zeigen, können hier die Erhebungen 16 und Vertiefungen 18 ringartig als konzentrische Ringe, beispielsweise kreisförmige Ringe oder elliptische Ringe, vorgesehen sein. Eine weitere Möglichkeit zeigt die Fig. 16, wo ein als eckige Platte ausgebildetes Piezokeramik-Bauteil 46 mit der Grundstruktur 14 versehen ist, deren Erhebungen 16 und Vertiefungen 18 als konzentrische Rechtecke ausgebildet sind.

Fig. 17 zeigt einen schneckenförmigen Verlauf der rillenartigen Erhebung 16 bzw. der benachbarten Vertiefung 18.

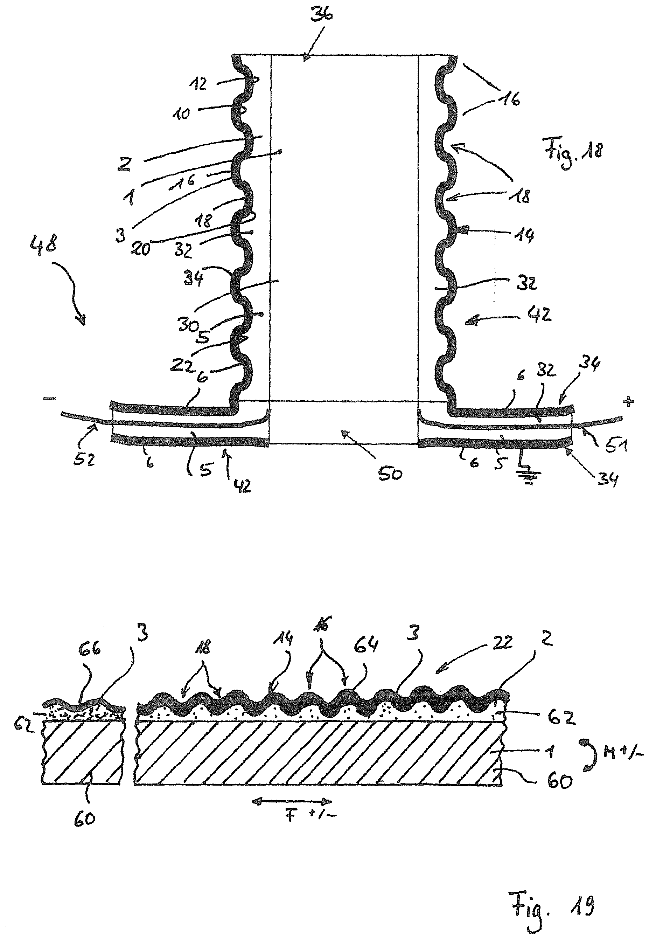

Fig. 18 zeigt in Seitenansicht anhand des Beispiels von Fig. 6, dass die Isolationsschicht 32 und die Metallschicht 34 auch vorteilhaft zum Erreichen einer möglichen Kabelanbindung 44 genutzt werden können. Hierzu ist anschließend an das Piezokeramik-Bauteil 36 ein passiver Baustein 50 vorgesehen, wobei seitlich zu diesem passiven Baustein 50 die Isolationsschicht 32 - erste Materialschicht 2 - links und rechts als Fortsatz weitergeführt wird, um zwei Anschlusskabel 51, 52 zu isolieren. Diese um die Anschlusskabel 51, 52 herum als Beschichtung vorgesehene Isolationsschicht 32 ist ebenfalls mit der Metallschicht 34 versehen.

Bei der Herstellung dieser möglichen Kabelanbindung 48 wird derart vorgegangen, dass zunächst in dem in Fig. 1 dargestellten Schritt als Substrat 1 das Piezokeramik-Bauteil 36 zusammen mit dem passiven Baustein 50 und den beiden Anschlusskabeln 51, 52 vorgesehen wird. Anschließend wird die Umfangsoberfläche 40 sowohl der Piezokeramik 30 als auch der beiden Anschlusskabel 51, 52 mit der ersten Materialschicht 2 versehen (Parylene), um so die Isolationsschicht 32 zu bilden. Anschließend erfolgt die Strukturierung der ersten Materialschicht 2, allerdings hier nur im Bereich der Umfangsoberfläche 40 der Piezokeramik 30. Anschließend wird die Metallschicht 34 aufgedampft, so dass sie an der Umfangsoberfläche 40 die Grundstruktur übernimmt, rund um den passiven Baustein 50 und die Anschlusskabel 51, 52 herum jedoch eine geradlinige Struktur erhält.

Wie dargestellt, ist das hier dargestellte Beschichtungsverfahren besonders vorteilhaft zum Vorsehen eines effektiven Feuchteschutzes und Vorsehen einer Schutzschicht mit weiteren Funktionen für Piezokeramiken. Die Erfindung ist jedoch nicht auf diesen Anwendungsfall beschränkt.

Fig. 19 zeigt eine weitere mit dem Verfahren gemäß den Fig. 1 bis 5 herstellbare Oberflächenschichtstruktur 22 am Beispiel eines Metallblechs 60 mit Lackierung als Schutzschicht 42. In diesem Beispiel bildet das Metallblech 60 das Substrat 1. Zum Beispiel ist hier als Metallblech 60 ein Aluminiumblech vorgesehen. Als erste Materialschicht 2 wird auf das Metallblech 20 eine Primerschicht 62 aufgebracht. Die Primerschicht 62 dient beispielsweise zur Haftvermittlung zwischen einem Lackmaterial und dem Metall des Metallblechs. Diese Primerschicht 62 bildet die erste Materialschicht 2. Diese Primerschicht 62 wird - beispielsweise mittels eines Lasers 4 - strukturiert, um die Grundstruktur 14 zu erhalten.

Auf diese entsprechend strukturierte Primerschicht 62 wird die zweite Materialschicht 3 dünn aufgetragen. Zum Beispiel wird hier ein harter Lack 64 (Top Coat) oder eine Wolfram-Carbit-Schicht 66 (Erosionsschutz) auf die Grundstruktur 14 aufgebracht, so dass der Lack 64 bzw. die Wolfram-Carbit-Schicht 66 der Grundstruktur mit Erhebungen 16 und Vertiefungen 18 folgt. Über zyklische Erwärmungen/Abkühlungen des Metallblechs 60 wird eine dynamische Belastung induziert, die zu einem Ausdehnen des Metallblechs 60 bzw. einem Zusammenziehen führt. Die als Lack 64 oder Wolfram-Carbit-Schicht 66 ausgebildete zweite Materialschicht 3 kann trotz ihrer größeren Härte aufgrund der Formung durch die Grundstruktur 14 diese dynamischen Belastungen nach Art eines Metallbalges ohne Weiteres mitmachen.

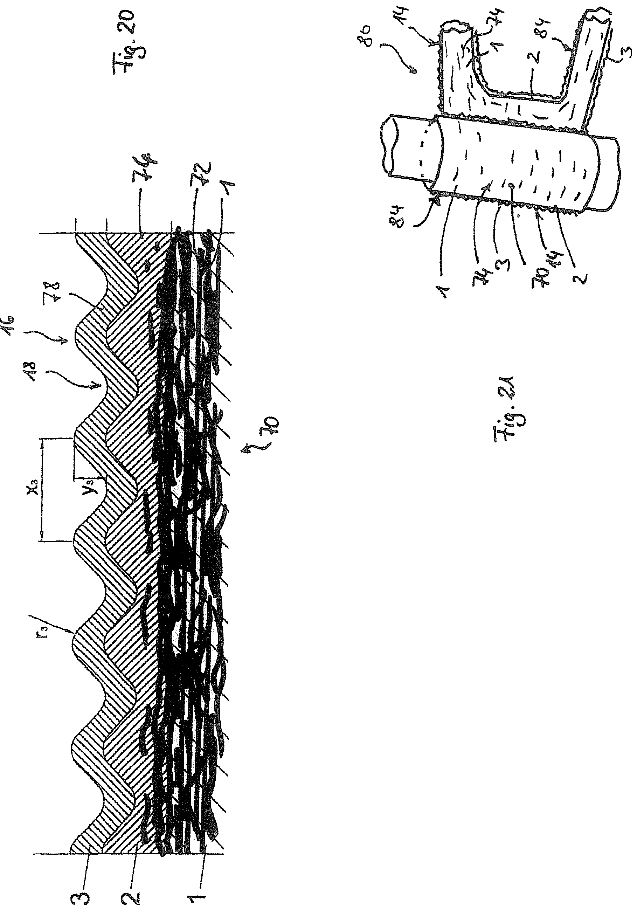

Fig. 20 zeigt ein drittes grundsätzliches Ausführungsbeispiel eines beschichteten CFK-Bauteils 70. Dieses CFK-Bauteil 70 weist als ein Substratmaterial Fasern 72, z.B. aus Kohlenstoff, auf. Die erste Materialschicht 2 ist durch das Harz 74 der Matrix des CFK-Bauteils 70 gebildet. Ein Laser 4 strukturiert das CFK-Material 76, so dass auf der Oberfläche des Harzes 74 die Grundstruktur 14 entsteht. Anschließend wird das strukturierte Harz 74 metallisiert, z.B. über galvanische Abscheidung, thermisches Spritzen, Kaltgasspritzen oder Plasmaabscheidung. Die so gebildete Metallschicht 78 bildet die zweite Materialschicht 3. Über eine zyklisehe Erwärmung oder Abkühlung des CFK-Bauteils 70 wird eine dynamische Belastung induziert. Die Metallschicht 78 kann aufgrund ihrer Ausformung dieser dynamischen Belastung ohne Weiteres folgen.

Fig. 21 zeigt ein weiteres Beispiel, wobei auf einem Festkörpergelenk 80 aus Faserwerkstoff 82 mit Harzmatrix 74 eine funktionelle Schutzschicht 84 zum UV-Schutz aufgebracht ist.

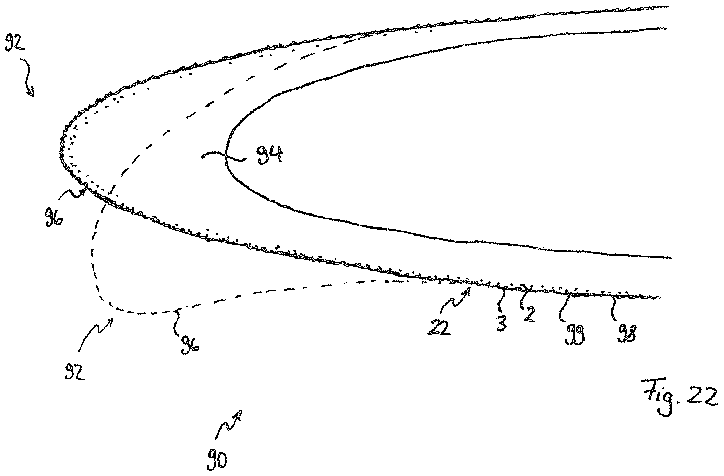

Fig 22 zeigt ein weiteres Ausführungsbeispiel. Gemäß diesem weiteren Ausführungsbeispiel ist ein verformbares aerodynamisches Bauteil 90 mit der Oberflächenstruktur 22 versehen. Die zweite Materialschicht hat z.B. die Funktion einer Erosionsschutzschicht. Aufgrund der Strukturierung kann die Oberflächenstruktur Verformungen des aerodynamischen Bauteils mitmachen.

Zum Beispiel ist das aerodynamische Bauteil 90 ein mittels nicht dargestellter Aktoren verformbares aerodynamisches Profil, z.B. zur Anwendung an Luftfahrzeugen als Flügelteil oder als Teil einer Steuerfläche oder eines Rotors oder z.B. in der Anwendung von Kraftanlagen, z.B. Wind- oder Wasserkraftrotorflügel oder dergleichen.

Als konkretes Anwendungsbeispiel zeigt die Grafik der Fig. 22 als aerodynamisches Bauteil 90 die Seitenansicht einer absenkbaren Flügelvorderkante 92 (Droop Nose), die sich mit Hilfe von Aktuatoren (nicht dargestellt) verformen lässt. Die Flügelvorderkante 92 besteht z.B. zu einem Großteil aus GFK 94 (glasfaserverstärkter Kunststoff), da dieser den geforderten Ansprüchen bzgl. Verformbarkeit (bis zu 2 %) gerecht wird. Um den hohen Erosionsbelastungen durch Regen und Sand zu widerstehen, wird die Vorderkante 92 mit einer erosionsstabilen Schicht 96 versehen. Dabei eignen sich z.B. thermisch gespritzte oder galvanisch abgeschiedene metallische Schichten 98.

Die metallische Schicht 98 wird gemäß dem hier erläuterten Beschichtungsverfahren als zweite Materialschicht 3 auf einer laserstrukturierten Primerschicht 99 (erste Materialschicht 2) aufgebracht. Die Flexibilität der strukturierten Primerschicht 99 unterstützt die Verformbarkeit der metallischen Schicht 98.

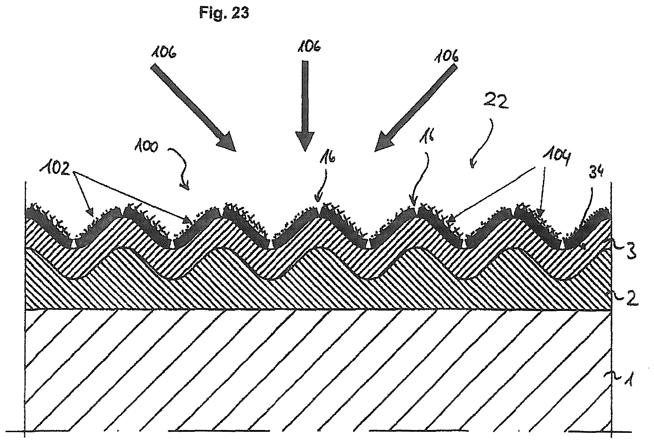

Fig. 22 zeigt die formvariable Flügelvorderkante 92 (Droop Nose) im Ausgangszustand (durchgezogene Linien und abgesenkten Zustand (gestrichelte Linie).
Ein weiteres Beispiel zum Anwenden der Oberflächenstruktur 22 ist in der Fig. 23 wiedergegeben. Hier wird die Strukturierung mit Erhebungen 16 und Vertiefungen 18 zur Erzeugung unterschiedlicher optischer Effekte je nach relativem Blickwinkel auf die Oberflächenschichtstruktur 22 ausgenutzt.

Die metallisch strukturierte Oberfläche 34 ermöglicht, eine Farbschicht 100 aufzutragen, deren Farbeffekt vom Betrachtungswinkel abhängt (siehe Fig. 23). Als denkbare Drucktechnik bietet sich z.B. der UV-Direktdruck an, der aus den jeweiligen Betrachtungsrichtungen das jeweils dazugehörige Teilbild aushärtet. Das Ergebnis können z.B. autostereoskopische Wechselbilder 102, 104 (ein "Wackelbild") sein. Der hierbei erzielte optische Effekt kann z.B. genutzt werden:
- für Marketingzwecke oder
- zur Funktionskontrolle.

Z.B. kann mit solchen optischen Effekten eine sensorlose Analyse von formvariablen Strukturen durchgeführt werden. Dies sei am Beispiel der formvariablen Flügelvorderkante 92 von Fig. 22 erläutert. Aufgrund des relativblickwinkelabhängigen optischen Effekts kann z.B. einfach durch Beobachten aus gleichbleibenden Blickwinkel (z.B. aus dem Cockpit eines Flugzeugs auf die Flügelvorderkante 92) ein zeitlicher Verlauf des Farbumschlags während des Absenkens beobachtet werden

Fig. 23 zeigt eine Farbbeschichtung 100 einer strukturierten Oberfläche zur Erzielung wechselnder Bildeffekte. Auf ersten Flanken 101 der Erhebungen 16 sind die Teilbereiche eines ersten Bildes 102 (z.B. roter Anstrich) aufgetragen und auf den den ersten Flanken entgegengesetzten zweiten Flanken 103 der Erhebungen 16 sind die Teilbereiche eines zweiten Bildes 104 (z.B. blauer Anstrich) aufgetragen. Je nach Blickwinkel 106 ergibt sich dann als optischer Effekt entweder das erste Bild 102 (z.B. rote Fläche), das zweite Bild 104 (z.B. blaue Fläche) oder eine Mischung aus erstem Bild 102 und zweitem Bild 104 (z.B. violette Fläche).

### Bezugszeichenliste

- 1: Substrat
- 2: erste Materialschicht
- 3: zweite Materialschicht
- 4: Strukturierungswerkzeug (Laserstrahl, lonenstrahl oder Elektronenstrahl)
- 5: erstes Material
- 6: zweites Material
- 10: Erhebungen (erstes Material)
- 12: Vertiefungen (erstes Material)
- 14: Grundstruktur
- 16: Erhebung (zweites Material)
- 18: Vertiefung (zweites Material)
- 20: Grenzfläche
- 22: Oberflächenschichtstruktur
- 30: Piezokeramik
- 32: Isolationsschicht
- 34: Metallschicht
- 36: Piezokeramik-Bauteil
- 38: Längsmittelachse
- 40: Umfangsoberfläche
- 42: Schutzschicht
- 44: weitere Schutzschicht
- 46: Piezokeramik-Bauteil
- 48: Kabelanbindung
- 50: passiver Baustein
- 51: Anschlusskabel
- 52: Anschlusskabel
- 60: Metallblech
- 62: Primerschicht
- 64: Lack
- 66: Wolfram-Carbit-Schicht
- 70: CFK-Bauteil
- 72: Fasern
- 74: Harz
- 76: CFK-Material
- 78: Metallschicht
- 80: Festkörpergelenk
- 82: Faserwerkstoff
- 84: Schutzschicht
- 90: aerodynamisches Bauteil
- 92: Flügelvorderkante
- 94: GFK
- 96: erosionsstabile Schicht
- 98: metallische Schicht
- 99: Primerschicht
- 100: Farbschicht
- 101: erste Flanke
- 102: erstes Bild
- 103: zweite Flanke
- 104: zweites Bild
- 106: Blickwinkel

## Patentansprüche

1. Beschichtungsverfahren zum Erzeugen einer Funktionsschicht auf einem Piezokeramikbauteil (36) mit den Schritten:
Bereitstellen einer ersten Materialschicht (2) aus einem ersten Material (5) mit einer höheren mechanischen Flexibilität als ein zweites Material (6) an oder auf einem Piezokeramikbauteil (36),
Strukturieren der ersten Materialschicht (2), so dass die Materialschicht-Oberfläche der ersten Materialschicht (2) eine dreidimensional ausgeformte Grundstruktur (14) mit Erhebungen (10) und Vertiefungen (12) erhält, und
Beschichten der Materialschicht-Oberfläche der ersten Materialschicht (2) mit einer zweiten Materialschicht (3) aus dem zweiten Material (6) derart, dass die zweite Materialschicht (3) im Wesentlichen die Grundstruktur (14) der Materialschicht-Oberfläche mit den Erhebungen (16) und Vertiefungen (18) annimmt,
**gekennzeichnet durch** wenigstens einen der folgenden Schritte:
a) ringförmiges Ausbilden der Erhebungen (16) und Vertiefungen (18) mit schräg zu einer Längsmittelachse des Piezokeramikbauteils verlaufenden Ringebenen oder
b) Ausbilden der Erhebungen (16) und Vertiefungen (18) mit einem doppelschrägen Verlauf oder
c) ringartiges Ausbilden der Erhebungen (16) und Vertiefungen (18) als konzentrische Ringe oder
d) Ausbilden der Erhebungen (16) und Vertiefungen (18) als konzentrisch umlaufende geometrische Formen, insbesondere Rechtecke, Fünfecke oder Achtecke, oder als ellipsoide konzentrische Formen oder
e) Ausbilden der Erhebungen (16) und Vertiefungen (18) mit einem schneckenförmigen Verlauf.

2. Beschichtungsverfahren nach Anspruch 1, **dadurch gekennzeichnet, dass** damit ein Feuchteschutz für ein Piezokeramikbauteil (36) hergestellt wird.

3. Beschichtungsverfahren nach einem der vorstehenden Ansprüche,
**dadurch gekennzeichnet,**
a) **dass** das erste Material (5) ausgewählt wird aus einer Gruppe von Materialien, die Metall, Kunststoff und Keramik enthält; und/oder
b) **dass** das zweite Material (6) ausgewählt wird aus einer Gruppe von Materialien, die Metall, Kunststoff und Keramik enthält.

4. Beschichtungsverfahren nach einem der voranstehenden Ansprüche, **gekennzeichnet durch**
Auswahl des ersten Materials (5) und des zweiten Materials (6) derart, dass das zweite Material (6)
• einen höheren E-Modul,
• eine höhere Härte,
• eine geringere Bruchdehnung, Brucheinschnürung, Bruchzähigkeit und/oder
• eine geringere dynamische Festigkeit
als das erste Material (5) hat.

5. Beschichtungsverfahren nach einem der voranstehenden Ansprüche, **gekennzeichnet durch**
Bereitstellen oder Ausbilden der ersten Materialschicht (2) sowohl als erste Funktionsschicht zur Bereitstellung wenigstens einer ersten Funktion als auch als Form zum Ausbilden der zweiten Materialschicht (3) und durch
Ausbilden der zweiten Materialschicht (3) als zweite Funktionsschicht zur Bereitstellung wenigstens einer zweiten Funktion.

6. Beschichtungsverfahren nach Anspruch 5,
**gekennzeichnet durch**
Bereitstellen oder Ausbilden der ersten Materialschicht (2) als
• Isolationsschicht (32) zur elektrischen Isolierung,
• Schutzschicht (42) gegen Feuchtigkeit und/oder
• elastische Pufferschicht zum elastischen Ausgleichen von Relativverschiebungen oder Relativbewegungen zwischen zweiter Materialschicht (3) und Substrat (1)
und/oder
Ausbilden der zweiten Materialschicht (3) als
• Schutzschicht (44) gegen chemische Belastung,
• Schutzschicht (44) gegen mechanische oder physikalische Belastung,
• Schutzschicht (44) gegen thermische Belastung,
• elektrisch leitende oder elektrisch isolierende Funktionsschicht, und/oder
• Feldbeeinflussungsschicht zum Beeinflussen von elektromagnetischen, elektrischen oder magnetischen Feldern.

7. Beschichtungsverfahren nach einem der voranstehenden Ansprüche,
**dadurch gekennzeichnet,**
**dass** der Schritt Strukturieren der ersten Materialschicht (2) wenigstens einen der folgenden Schritte enthält:
• mikroskopisches Strukturieren der erste Materialschicht (2) mittels eines energetischen Strahls, insbesondere einem Laser-, lonen- oder Elektronenstrahl;
• thermisches mikroskopisches Strukturieren mittels einer erhitzten Gegenform; und/oder
• mikroskopisches Prägen der Grundstruktur (14) auf der Materialschicht-Oberfläche.

8. Beschichtungsverfahren nach einem der voranstehenden Ansprüche,
**dadurch gekennzeichnet,**
**dass** der Schritt Strukturieren der ersten Materialschicht (2) wenigstens einen der folgenden Schritte enthält:
• Auswählen der Grundstruktur (14) oder Auswählen der Form und der Größenabmessungen der Grundstruktur (14) aufgrund wenigstens eines der folgenden Kriterien:
∘ Höhe einer zu erwartenden Belastung,
∘ Art einer zu erwartenden Belastung,
∘ erwünschter oder gegebener Verformungsweg,
∘ Umgebungseinflüsse auf das Bauteil oder die Oberfläche;
und/oder
• Ausbilden der Grundstruktur (14) mit einer periodischen Folge von Vertiefungen (12, 18) und Erhebungen (10, 16).

9. Piezokeramikbauteil (36) mit einem Schutzschichtsystem zum Feuchteschutz und/oder zum Schutz gegen mechanische Beanspruchung, wobei das Schutzschichtsystem durch ein Beschichtungsverfahren nach einem der vorhergehenden Ansprüche herstellbar ist.

## Claims

1. Coating method for producing a functional layer on a piezo ceramic component (36), comprising the steps of:
providing of a first material layer (2) made of a first material (5) having a mechanical flexibility higher than that of a second material (6) at or on the piezo ceramic component (36),
structuring the first material layer (2) so that the material layer surface of the first material layer (2) is given a three-dimensionally moulded basic structure (14) with projections (10) and recesses (12), and
coating the material layer surface of the first material layer (2) with a second material layer (3) made from the second material (6), such that the second material layer (3) substantially adopts the basic structure (14) of the material layer surface with the projections (16) and recesses (18),
**characterized by** at least one of the following steps:
a) annularly forming of the projections (16) and recesses (18) with ring planes extending obliquely relative to a longitudinal central axis of the piezo ceramic component, or
b) forming of the projections (16) and recesses (18) with a dual inclination, or
c) annularly forming of the projections (16) and recesses (18) as concentric rings, or
d) forming of the projections (16) and recesses (18) as concentric circumferential geometric shapes, in particular rectangles, pentagons or octagons, or as ellipsoidal concentric shapes, or
e) forming of the projections (16) and recesses (18) with a helical path.

2. Coating method according to claim 1, **characterized in that** by this method a moisture protection for a piezo ceramic component (36) is manufactured.

3. Coating method according to any of the preceding claims,
**characterized in**
a) **that** the first material (5) is selected from a group of materials including metal, plastic and ceramic; and/or
b) **that** the second material (6) is selected from a group of materials including metal, plastic and ceramic.

4. Coating method according to any of the preceding claims,
**characterized by**
selection of the first material (5) and the second material (6) such that the second material (6) has
• a higher elastic modulus,
• a higher hardness,
• a lower breaking elongation, reduction of area at break, fracture toughness at break, and/or
• a lower dynamic strength
than the first material (5).

5. Coating method according to any of the preceding claims,
**characterized by**
providing or forming of the first material layer (2) both as a first functional layer for providing at least a first function or as mould for forming of the second material layer (3), and by
the formation of the second material layer (3) as a second functional layer for providing at least one second function.

6. Coating method according to claim 5,
**characterized by**
providing or forming the first material layer (2) as
• an insulating layer (32) for electric insulation,
• a protective layer (42) for protection from moisture, and/or
• a resilient buffer layer for resilient balancing of relative displacements or relative movements between the second material layer (3) and the substrate (1)
and/or
forming of the second material layer (3) as
• a protective layer (44) for protection from chemical loads,
• a protective layer (44) for protection from mechanical or physical loads,
• a protective layer (44) for protection from thermal loads,
• an electrically conductive or electrically insulating function layer, and/or
• a field-influencing layer for influencing electromagnetic, electric or magnetic fields.

7. Coating method according to any of the preceding claims,
**characterized in**
**that** the step of structuring the first material layer (2) includes at least one of the following steps:
• microscopic structuring of the first material layer (2) by means of an energetic beam, in particular a laser, ion or electron beam;
• thermal microscopic structuring by means of a heated counter-mould; and/or
• microscopic embossing the basic structure (14) on the material layer surface.

8. Coating method according to any of the preceding claims,
**characterized in**
**that** the step of structuring the first material layer (2) includes at least one of the following steps:
• selecting the basic structure (14) or selecting the shape and the size dimensions of the basic structure (14) based on at least one of the following criteria:
∘ level of a load to be expected,
∘ type of a load to be expected,
∘ desired or predetermined deformation path,
∘ influence from the environment on the component or the surface;
and/or
• forming of the basic structure (14) with a periodical succession of recesses (12, 18) and projections (10, 16).

9. Piezo ceramic component (36) having a protective layer structure (22) protection from moisture and/or for protection from mechanical loads, wherein the protective layer structure is obtainable by performing a coating method according to any of the preceding claims.

## Revendications

1. Procédé de revêtement pour engendrer une couche fonctionnelle sur un composant piézocéramique (36), comprenant les étapes consistant à :
préparer une première couche de matériau (2) en un premier matériau (5) présentant une flexibilité mécanique plus élevée qu'un second matériau (6) sur ou contre un composant piézocéramique (36),
structurer la première couche de matériau (2) de telle sorte que la surface de la première couche de matériau (2) présente une structure de base (14) à conformation tridimensionnelle avec des reliefs (10) et des creux (12), et
revêtir la surface de la première couche de matériau (2) avec une seconde couche de matériau (3) à partir du second matériau (6), de telle façon que la seconde couche de matériau (3) adopte sensiblement la structure de base (14) de la surface avec les saillies (16) et les creux (18),
**caractérisé par** l'une au moins des étapes suivantes consistant à :
a) réaliser sous forme annulaire les reliefs (16) et les creux (18) avec des plans annulaires s'étendant en oblique par rapport à un axe médian longitudinal du composant piézocéramique, ou
b) réaliser les reliefs (16) et les creux (18) avec un tracé oblique double, ou
c) réaliser sous forme annulaire les reliefs (16) et les creux (18) sous forme d'anneaux concentriques, ou
d) réaliser les reliefs (16) et les creux (18) comme des formes géométriques circonférentielles concentriques, en particulier des rectangles, des pentagones ou des octogones, ou comme des formes ellipsoïdales concentriques, ou
e) réaliser les reliefs (16) et les creux (18) avec un tracé en forme d'escargot.

2. Procédé de revêtement selon la revendication 1, **caractérisé en ce que** l'on réalise ainsi une protection anti humidité pour un composant piézocéramique (36).

3. Procédé de revêtement selon l'une des revendications précédentes,
**caractérisé en ce que**
a) le premier matériau (5) est sélectionné parmi un groupe de matériaux qui contient des métaux, des matières plastiques et des céramiques ; et/ou
b) le second matériau (6) est sélectionné parmi un groupe de matériaux qui contient des métaux, des matières plastiques et des céramiques.

4. Procédé de revêtement selon l'une des revendications précédentes,
**caractérisé en ce que** l'on sélectionne le premier matériau (5) et le second matériau (6) de telle façon que le second matériau (6) présente :
- un module d'élasticité plus élevé,
- une dureté plus élevée,
- un allongement à la rupture plus faible, une striction à la rupture plus faible, une ténacité à la rupture plus faible, et/ou
- une solidité dynamique plus faible
**que** le premier matériau (5).

5. Procédé de revêtement selon l'une des revendications précédentes,
**caractérisé en ce que**
on prépare ou on réalise la première couche de matériau (2) à la fois à titre de première couche fonctionnelle pour procurer au moins une première fonction, et à titre de moule pour réaliser la seconde couche de matériau (3), et **en ce que**
on réalise la seconde couche de matériau (3) à titre de seconde couche fonctionnelle pour procurer au moins une seconde fonction.

6. Procédé de revêtement selon la revendication 5,
**caractérisé en ce que**
on prépare ou on réalise la première couche de matériau (2) à titre de
- couche d'isolation (32) pour l'isolation électrique,
- couche de protection (42) à l'encontre de l'humidité, et/ou
- couche tampon élastique pour la compensation élastique de déplacements ou de mouvements relatifs entre la seconde couche de matériau (3) et un substrat (1)
et/ou
on réalise la seconde couche de matériau (3) à titre de
- couche de protection (44) à l'encontre de sollicitations chimiques,
- couche de protection (44) à l'encontre de sollicitations mécaniques ou physiques,
- couche de protection (44) à l'encontre de sollicitations thermiques,
- couche fonctionnelle électroconductrice ou électriquement isolante, et/ou
- couche d'influence de champ pour influencer des champs électromagnétiques, électriques ou magnétiques.

7. Procédé de revêtement selon l'une des revendications précédentes,
**caractérisé en ce que**
l'étape consistant à structurer la première couche de matériau (2) comprend l'une au moins des opérations suivantes :
- structuration microscopique de la première couche de matériau (2) au moyen d'un faisceau énergétique, en particulier d'un faisceau laser, d'un faisceau ionique ou d'un faisceau d'électrons ;
- structuration microscopique thermique au moyen d'une forme antagoniste chauffée ; et/ou
- impression microscopique de la structure de base (14) sur la surface de la couche de matériau.

8. Procédé de revêtement selon l'une des revendications précédentes,
**caractérisé en ce que**
l'étape consistant à structurer la première couche de matériau (2) comprend l'une au moins des opérations suivantes :
- sélection de la structure de base ou sélection de la forme et des dimensions de la structure de base (14) sur la base de l'un au moins des critères suivants :
- intensité d'une sollicitation prévue,
- type d'une sollicitation prévue,
- course de déformation souhaitée ou imposée,
- influences environnementales sur le composant ou sur la surface ; et/ou
- réalisation de la structure de base (14) avec une succession périodique de creux (12, 18) et de reliefs (10, 16).

9. Composant piézocéramique (36) comportant un système de couche de protection pour la protection anti humidité et/ou pour la protection à l'encontre des sollicitations mécaniques, dans lequel le système de couche de protection est susceptible d'être réalisé par un procédé de revêtement selon l'une des revendications précédentes.
